# EUROPÄISCHE PATENTANMELDUNG

(11) **EP 3 121 856 A1**
(43) Veröffentlichungstag der Anmeldung: **25.01.2017**
(21) Anmeldenummer: 16187697.4
(22) Anmeldetag: 23.07.2014
(51) Int. Cl.: H01L 31/18, H01L 31/068, H01L 31/0236, C03C 23/00, C03C 17/34

(54) **VERFAHREN ZUR HERSTELLUNG EINER SOLARZELLE, INSBESONDERE EINER SILIZIUM-DÜNNSCHICHT-SOLARZELLE**

(30) Priorität: 24.07.2013 DE 102013107910
(62) Teilanmeldung aus: 14744304.8
(71) Anmelder: Lilas GmbH, 44319 Dortmund (DE)
(72) Erfinder: Lissotschenko, Vitalij, 58730 Fröndenberg (DE)
(74) Vertreter: Basfeld, Rainer

(57) **Zusammenfassung**

Verfahren zur Herstellung einer Solarzelle, insbesondere einer Silizium-Dünnschicht-Solarzelle, bei der eine TCO-Schicht (3) auf ein Glassubstrat (1) und auf die TCO-Schicht (3) mindestens eine Siliziumschicht (4, 5) aufgebracht wird, wobei auf die TCO-Schicht (3) eine erste Siliziumschicht (4) aufgebracht wird, wobei die erste Siliziumschicht (4) mit einer Laserstrahlung oder einer Elektronenstrahlung beaufschlagt wird und wobei eine zweite Siliziumschicht (5) auf die bestrahlte erste Siliziumschicht (4) aufgebracht wird.

## Beschreibung

Die vorliegende Erfindung betrifft ein Verfahren zur Herstellung einer Solarzelle, insbesondere einer Silizium-Dünnschicht-Solarzelle, gemäß dem Oberbegriff des Anspruchs 1.

Silizium-Dünnschicht-Solarzellen finden vielfältige Anwendungen. Häufig weisen diese einen zu geringen Wirkungsgrad auf, weil das Licht nur zu einem geringen Teil in der mindestens einen Siliziumschicht absorbiert wird. Dies hat teilweise seinen Grund darin, dass bei manchen der aus dem Stand der Technik bekannten Solarzellen keine dicken Siliziumschichten eingesetzt werden oder werden können.

Das der vorliegenden Erfindung zugrunde liegende Problem ist die Angabe eines Verfahrens der eingangs genannten Art, das die Fertigung von Solarzellen mit einem höheren Wirkungsgrad ermöglicht.

Dies wird erfindungsgemäß durch ein Verfahren der eingangs genannten Art mit den kennzeichnenden Merkmalen des Anspruchs 1 erreicht. Die Unteransprüche betreffen bevorzugte Ausgestaltungen der Erfindung.

Gemäß Anspruch 1 ist vorgesehen, dass auf die TCO-Schicht eine erste Siliziumschicht aufgebracht wird, dass die erste Siliziumschicht mit einer Laserstrahlung oder einer Elektronenstrahlung beaufschlagt wird und dass eine zweite Siliziumschicht auf die bestrahlte erste Siliziumschicht aufgebracht wird. Durch den modularen Aufbau der Siliziumschicht ist diese vergleichsweise beständig. Dadurch kann zumindest die zweite Siliziumschicht mit einer größeren Dicke versehen werden, wodurch auch die Absorption des Lichts vergrößert werden kann.

Es kann dabei vorgesehen werden, dass die zweite Siliziumschicht dicker als die erste Siliziumschicht ist. Es besteht die Möglichkeit, dass die erste Siliziumschicht eine Schichtdicke von weniger als 3,0 µm, insbesondere eine Schichtdicke von weniger als 2,0 µm, vorzugsweise eine Schichtdicke von weniger als 1,0 µm, beispielsweise eine Schichtdicke zwischen 0,5 µm und 1,0 µm aufweist. Weiterhin kann dabei vorgesehen werden, dass die zweite Siliziumschicht eine Schichtdicke zwischen 2,0 µm und 20 µm, insbesondere eine Schichtdicke zwischen 3,5 µm und 15 µm, vorzugsweise eine Schichtdicke zwischen 5 µm und 10 µm aufweist. Durch eine derartige Gestaltung kann erreicht werden, dass die Siliziumschichten sicher auf der TCO-Schicht halten und dass trotzdem durch die große Dicke der zweiten Siliziumschicht eine hohe Absorption und damit ein großer Wirkungsgrad der Solarzelle erreicht wird.

Es besteht die Möglichkeit, dass vor dem Aufbringen der TCO-Schicht das Glassubstrat mit einer Elektronenstrahlung beaufschlagt wird, so dass eine Licht streuende Schicht des Glassubstrats entsteht, auf die die TCO-Schicht aufgebracht wird. Durch diese Licht streuende Schicht kann das von der Solarzelle zu absorbierende Licht so gestreut werden, dass Anteile dieses Lichts seitlich abgelenkt werden beziehungsweise unter einem Winkel größer 0° zum Einfallslot verlaufen. Dadurch können diese Anteile des Lichts einen längeren Weg durch die mindestens eine Siliziumschicht zurücklegen, so dass sich deren Absorption vergrößert.

Es kann vorgesehen sein, dass das Glassubstrat vor und/oder während der Beaufschlagung mit der Elektronenstrahlung aufgeheizt wird, insbesondere auf eine Temperatur zwischen 200° C und 700° C, vorzugsweise auf eine Temperatur zwischen 300° C und 500° C, beispielsweise auf eine Temperatur von 400° C. Durch die Bestrahlung mit dem Elektronenstrahl bei gleichzeitiger Erwärmung können leichtere Bestandteile des Glases zumindest teilweise dazu gebracht werden, aus der Oberfläche heraus zu diffundieren. Durch dieses Herausdiffundieren von Bestandteilen des Glases entstehen in der Schicht Licht streuende Strukturen.

Es besteht die Möglichkeit, dass die Elektronenstrahlung einen linienförmigen Querschnitt aufweist und senkrecht zur Längserstreckung der Linie über die Oberfläche des Glassubstrats bewegt wird. Auf diese Weise kann die Oberfläche des Glassubstrats einerseits vergleichsweise schnell mit der Elektronenstrahlung beaufschlagt werden. Andererseits ist die lokale Leistungsdichte nicht so hoch wie bei dem Bewegen einer punktförmigen Intensitätsverteilung über die Oberfläche des Glassubstrats.

Es kann insbesondere vorgesehen sein, dass die Aufbringung der TCO-Schicht und/oder der mindestens einen Siliziumschicht bei Temperaturen unterhalb von 300°C, vorzugsweise bei Temperaturen unterhalb von 200°C, insbesondere bei Temperaturen unterhalb von 100°C, beispielsweise bei Raumtemperatur erfolgt. Durch diese Maßnahme wird einerseits das erfindungsgemäße Verfahren vereinfacht, weil während der Aufbringung der TCO-Schicht und/oder der mindestens einen Siliziumschicht nicht geheizt werden muss. Andererseits wird durch die Beschichtung bei den genannten niedrigen Temperaturen, insbesondere bei Raumtemperatur eine temperaturinduzierte Beeinträchtigung oder Beschädigung der zu fertigenden Solarzelle verhindert.

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Darin zeigen
- Fig. 1: einen schematischen Schnitt durch eine erste mit einem erfindungsgemäßen Verfahren hergestellte Solarzelle;
- Fig. 2: einen schematischen Schnitt durch eine zweite mit einem erfindungsgemäßen Verfahren hergestellte Solarzelle;
- Fig. 3: einen schematischen Schnitt durch eine dritte mit einem erfindungsgemäßen Verfahren hergestellte Solarzelle.

In den Figuren sind gleiche oder funktional gleiche Teile oder Schichten mit gleichen Bezugszeichen versehen.

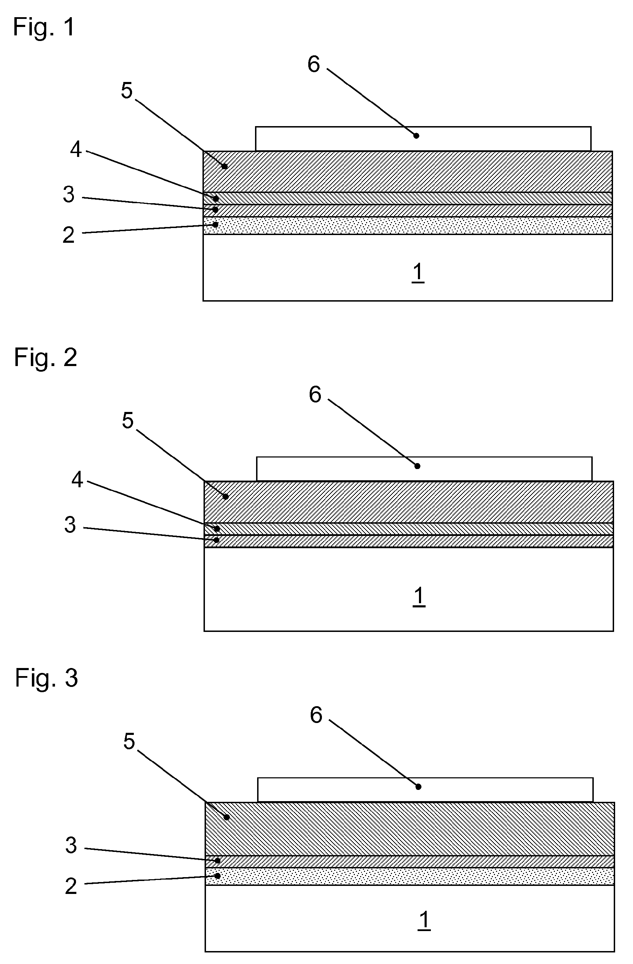

Bei einer ersten Ausführungsvariante der erfindungsgemäßen Verfahren wird ein Glassubstrat 1 auf eine Temperatur zwischen 200° C und 700° C, vorzugsweise auf eine Temperatur zwischen 300° C und 500° C, beispielsweise auf eine Temperatur von 400° C aufgeheizt und auf der in Fig. 1 oben angeordneten Oberfläche mit Elektronenstrahlung beaufschlagt. Insbesondere wird dabei ein Elektronenstrahl mit einem linienförmigen Querschnitt senkrecht zur Linienrichtung über die Oberfläche des Glassubstrats 1 bewegt.

Durch die Bestrahlung mit dem Elektronenstrahl bei gleichzeitiger Erwärmung werden in einer Schicht 2 des Glassubstrats 1 leichtere Bestandteile des Glases teilweise dazu gebracht, aus der Oberfläche heraus zu diffundieren. Es kann sich bei diesen Bestandteilen beispielsweise um Na₂O, K₂O, MgO oder CaO handeln. Durch dieses Herausdiffundieren von Bestandteilen des Glases entstehen in der Schicht 2 Licht streuende Strukturen.

Auf diese Schicht 2 wird in einem weiteren Verfahrensschritt eine TCO-Schicht 3 aufgebracht, die als erste Elektrode der Solarzelle dienen kann. Dies kann mit üblichen Aufbringmethoden, wie beispielsweise dem Aufsputtern geschehen. Insbesondere kann dabei das auszudampfende Material mit einem Elektronenstrahl verdampft werden. Bei der Aufbringung der TCO-Schicht 3 kann sich das Glassubstrat 1 auf Raumtemperatur befinden.

Als TCO-Material kann beispielsweise ZnO verwendet werden. Es besteht aber durchaus auch die Möglichkeit, andere TCO-Materialien, insbesondere andere Zinn- oder Zinkmischoxide, wie beispielsweise ITO, FTO, AZO und ATO, aufzubringen.

Die TCO-Schicht 3 wird in einem weiteren Verfahrensschritt mit Laserstrahlung beaufschlagt, um den Widerstand der TCO-Schicht 3 zu reduzieren. Dabei kann ein Laserstrahl mit einem linienförmigen Querschnitt verwendet werden, der senkrecht zur Linienrichtung über die Oberfläche der TCO-Schicht 3 bewegt wird. Auch bei der Beaufschlagung mit Laserstrahlung kann sich das Glassubstrat 1 auf Raumtemperatur befinden.

Auf die auf Weise bearbeitete TCO-Schicht 3 wird in einem nächsten Verfahrensschritt eine vergleichsweise dünne erste Siliziumschicht 4 aufgebracht. Die erste Siliziumschicht 4 kann eine Schichtdicke von weniger als 3,0 µm, insbesondere eine Schichtdicke von weniger als 2,0 µm, vorzugsweise eine Schichtdicke von weniger als 1,0 µm, beispielsweise eine Schichtdicke zwischen 0,5 µm und 1,0 µm aufweisen.

Die erste Siliziumschicht 4 kann mit üblichen Methoden, wie beispielsweise dem Aufsputtern aufgebracht werden. Insbesondere kann dabei das auszudampfende Silizium mit einem Elektronenstrahl verdampft werden. Bei der Aufbringung der erste Siliziumschicht 4 kann sich das Glassubstrat 1 auf Raumtemperatur befinden.

Die erste Siliziumschicht 4 wird in einem weiteren Verfahrensschritt mit Laserstrahlung oder Elektronenstrahlung beaufschlagt, wobei insbesondere eine Unstrukturierung der ersten Siliziumschicht 4 stattfinden kann, die ihre Haftung auf der TCO-Schicht 3 verbessert. Insbesondere ist die erste Siliziumschicht 4 nach dieser Laserbestrahlung oder Elektronenbestrahlung kratzfest.

Dabei kann ein Laserstrahl oder ein Elektronenstrahl mit einem linienförmigen Querschnitt verwendet werden, der senkrecht zur Linienrichtung über die Oberfläche der ersten Siliziumschicht 4 bewegt wird. Auch bei dieser Beaufschlagung mit Laserstrahlung oder Elektronenstrahlung kann sich das Glassubstrat 1 auf Raumtemperatur befinden.

Auf die erste Siliziumschicht 4 wird in einem nächsten Verfahrensschritt eine vergleichsweise dicke zweite Siliziumschicht 5 aufgebracht. Die zweite Siliziumschicht 5 kann eine Schichtdicke zwischen 2,0 µm und 20 µm, insbesondere eine Schichtdicke zwischen 3,5 µm und 15 µm, vorzugsweise eine Schichtdicke zwischen 5 µm und 10 µm aufweisen.

Die zweite Siliziumschicht 5 kann mit üblichen Methoden, wie beispielsweise dem Aufsputtern aufgebracht werden. Insbesondere kann dabei das auszudampfende Silizium mit einem Elektronenstrahl verdampft werden. Bei der Aufbringung der zweiten Siliziumschicht 5 kann sich das Glassubstrat 1 auf Raumtemperatur befinden.

Die zweite Siliziumschicht 5 wird in einem weiteren Verfahrensschritt mit Laserstrahlung oder Elektronenstrahlung beaufschlagt, wobei insbesondere eine Umstrukturierung der zweiten Siliziumschicht 5 von einem amorphen in einen polykristallinen Zustand stattfinden kann.

Dabei kann ein Laserstrahl oder ein Elektronenstrahl mit einem linienförmigen Querschnitt verwendet werden, der senkrecht zur Linienrichtung über die Oberfläche der zweiten Siliziumschicht 5 bewegt wird. Auch bei dieser Beaufschlagung mit Laserstrahlung oder Elektronenstrahlung kann sich das Glassubstrat 1 auf Raumtemperatur befinden.

In einem weiteren Verfahrensschritt wird auf die Außenseite der zweiten Siliziumschicht 5 eine in Fig. 1 nur schematisch angedeutete zweite metallische Elektrode 6 aufgebracht. Diese kann sich vollflächig über die zweite Siliziumschicht 5 erstrecken oder wie angedeutet auch nur einzelne Bereiche der zweite Siliziumschicht 5 abdecken.

Es besteht durchaus die Möglichkeit, bei einem erfindungsgemäßen Verfahren auf die Vorbehandlung des Glassubstrats 1 mit Elektronenstrahlung zu verzichten. In Fig. 2 ist eine Ausführungsform einer Solarzelle angedeutet, bei der auf die Erstellung der Streuschicht 2 verzichtet wurde.

In diesem Fall kann die TCO-Schicht 3 direkt auf das nicht mit einem Elektronenstrahl vorbehandelte Glassubstrat 1 aufgebracht werden. Alternativ dazu kann auf das Glassubstrat 1 vor Aufbringung der TCO-Schicht 3 eine Pufferschicht aufgebracht werden. Diese Pufferschicht kann vorzugsweise aus Silizium-Dioxid, -Nitrit, oder -Carbid bestehen und beispielsweise zwischen 10 nm und 200 nm, insbesondere zwischen 20 nm und 100 nm dick sein.

Es besteht weiterhin die Möglichkeit, auch auf ein erfindungsgemäß mit Elektronenstrahlung vorbehandeltes Glassubstrat 1 eine Pufferschicht aufzubringen. Auch diese Pufferschicht kann vorzugsweise aus Silizium-Dioxid, -Nitrit, oder -Carbid bestehen und beispielsweise zwischen 10 nm und 200 nm, insbesondere zwischen 20 nm und 100 nm dick sein.

Es besteht weiterhin die Möglichkeit, bei einem erfindungsgemäßen Verfahren die Siliziumschicht nicht modular aus zwei Teilschichten zusammenzusetzen, sondern lediglich eine Siliziumschicht vorzusehen. In Fig. 3 ist eine Ausführungsform einer Solarzelle angedeutet, bei der zwar eine Streuschicht 2 erstellt wurde, wobei aber auf die dünne erste Siliziumschicht 4 verzichtet wurde. In diesem Fall wird erfindungsgemäß die vergleichsweise dicke Siliziumschicht 5 direkt auf die TCO-Schicht 3 aufgebracht.

## Patentansprüche

1. Verfahren zur Herstellung einer Solarzelle, insbesondere einer Silizium-Dünnschicht-Solarzelle, umfassend folgende Verfahrensschritte:
- Aufbringen einer TCO-Schicht (3) auf ein Glassubstrat (1);
- Aufbringen mindestens einer Siliziumschicht (4, 5) auf die TCO-Schicht (3);
**dadurch gekennzeichnet, dass** auf die TCO-Schicht (3) eine erste Siliziumschicht (4) aufgebracht wird, dass die erste Siliziumschicht (4) mit einer Laserstrahlung oder einer Elektronenstrahlung beaufschlagt wird und dass eine zweite Siliziumschicht (5) auf die bestrahlte erste Siliziumschicht (4) aufgebracht wird.

2. Verfahren zur Herstellung einer Solarzelle nach Anspruch 1, **dadurch gekennzeichnet, dass** die zweite Siliziumschicht (5) dicker als die erste Siliziumschicht (4) ist.

3. Verfahren zur Herstellung einer Solarzelle nach einem der Ansprüche 1 oder 2, **dadurch gekennzeichnet, dass** die erste Siliziumschicht (4) eine Schichtdicke von weniger als 3,0 µm, insbesondere eine Schichtdicke von weniger als 2,0 µm, vorzugsweise eine Schichtdicke von weniger als 1,0 µm, beispielsweise eine Schichtdicke zwischen 0,5 µm und 1,0 µm aufweist.

4. Verfahren zur Herstellung einer Solarzelle nach einem der Ansprüche 1 bis 3, **dadurch gekennzeichnet, dass** die zweite Siliziumschicht (5) eine Schichtdicke zwischen 2,0 µm und 20 µm, insbesondere eine Schichtdicke zwischen 3,5 µm und 15 µm, vorzugsweise eine Schichtdicke zwischen 5 µm und 10 µm aufweist.

5. Verfahren zur Herstellung einer Solarzelle nach einem der Ansprüche 1 bis 4, **dadurch gekennzeichnet, dass** die zweite Siliziumschicht (5) mit einer Laserstrahlung oder einer Elektronenstrahlung beaufschlagt wird.

6. Verfahren zur Herstellung einer Solarzelle nach einem der Ansprüche 1 bis 5, **dadurch gekennzeichnet, dass** vor dem Aufbringen der TCO-Schicht (3) das Glassubstrat (1) mit einer Elektronenstrahlung beaufschlagt wird, so dass eine Licht streuende Schicht (2) des Glassubstrats (1) entsteht, auf die die TCO-Schicht (3) aufgebracht wird.

7. Verfahren zur Herstellung einer Solarzelle nach einem der Ansprüche 1 bis 6, **dadurch gekennzeichnet, dass** das Glassubstrat (1) vor und/oder während der Beaufschlagung mit der Elektronenstrahlung aufgeheizt wird, insbesondere auf eine Temperatur zwischen 200° C und 700° C, vorzugsweise auf eine Temperatur zwischen 300° C und 500° C, beispielsweise auf eine Temperatur von 400° C.

8. Verfahren zur Herstellung einer Solarzelle nach einem der Ansprüche 1 bis 7, **dadurch gekennzeichnet, dass** die Elektronenstrahlung einen linienförmigen Querschnitt aufweist und senkrecht zur Längserstreckung der Linie über die Oberfläche des Glassubstrats (1) bewegt wird.

9. Verfahren zur Herstellung einer Solarzelle nach einem der Ansprüche 1 bis 8, **dadurch gekennzeichnet, dass** die TCO-Schicht (3) mit einer Laserstrahlung beaufschlagt wird.

10. Verfahren zur Herstellung einer Solarzelle nach einem der Ansprüche 1 bis 9, **dadurch gekennzeichnet, dass** die Laserstrahlung oder die Elektronenstrahlung einen linienförmigen Querschnitt aufweist und senkrecht zur Längserstreckung der Linie über die Oberfläche des Glassubstrats (1) bewegt wird.

11. Verfahren zur Herstellung einer Solarzelle nach einem der Ansprüche 1 bis 10, **dadurch gekennzeichnet, dass** die TCO-Schicht (3) und/oder die mindestens eine Siliziumschicht (4, 5) vermittels eines Elektronenstrahls aufgedampft werden.

12. Verfahren zur Herstellung einer Solarzelle nach einem der Ansprüche 1 bis 11, **dadurch gekennzeichnet, dass** die Aufbringung der TCO-Schicht (3) und/oder der mindestens einen Siliziumschicht (4, 5) bei Temperaturen unterhalb von 300°C, vorzugsweise bei Temperaturen unterhalb von 200°C, insbesondere bei Temperaturen unterhalb von 100°C, beispielsweise bei Raumtemperatur erfolgt.

13. Verfahren zur Herstellung einer Solarzelle nach einem der Ansprüche 1 bis 12, **dadurch gekennzeichnet, dass** auf die mindestens eine Siliziumschicht (4, 5) beziehungsweise die zweite Siliziumschicht (5) eine Elektrode (6) aus einem elektrisch leitfähigen Material aufgebracht wird.
